(19) Europäisches Patentamt
European Patent Office
Office européen des brevets

(11) **EP 1 677 274 A1**

(12) **EUROPEAN PATENT APPLICATION**
published in accordance with Art. 158(3) EPC

(43) Date of publication:
05.07.2006 Bulletin 2006/27

(51) Int Cl.:
*G09F 9/00* (1968.09)     *G09F 9/30* (1968.09)
*H05B 33/12* (1968.09)

(21) Application number: 04792873.4

(22) Date of filing: 22.10.2004

(86) International application number:
**PCT/JP2004/015731**

(87) International publication number:
**WO 2005/041155 (06.05.2005 Gazette 2005/18)**

(84) Designated Contracting States:
**AT BE BG CH CY CZ DE DK EE ES FI FR GB GR HU IE IT LI LU MC NL PL PT RO SE SI SK TR**

(30) Priority: 24.10.2003 JP 2003364825

(71) Applicant: **Toshiba Matsushita Display Technology Co., Ltd.**
**Minato-ku,**
**Tokyo 108-0075 (JP)**

(72) Inventor: **HISATAKE, Yuzo**
**c/o I.P.D., Toshiba Mat.Disp.Tech.**
**Tokyo 108-0075 (JP)**

(74) Representative: **HOFFMANN EITLE**
**Patent- und Rechtsanwälte**
**Arabellastrasse 4**
**81925 München (DE)**

(54) **DISPLAY**

(57)     A display device includes selective reflection layers SR that are disposed between a 1/4 wavelength plate WP and a light-emitting layer 64, include liquid crystal molecules that are aligned with a predetermined helical pitch, pass first circularly polarized light, and reflect second circularly polarized light that has a polarity opposite to a polarity of the first circular polarized light and has a predetermined wavelength. The light-emitting layer 64 has at least one peak wavelength, and the selective reflection layers SR include an m-number of selective reflection regions when the number of peak wavelengths is m. When a peak wavelength of light emerging from the light-emitting layer 64 is λp(k)(k = 1, 2, ..., m in an order from a smallest wavelength), the peak wavelength λp(k) is less than a value ne(k)P(k) that is obtained by multiplying an extraordinary-ray refractive index ne(k) of the selective reflection layer SR that forms each selective reflection region by a helical pitch P(k), and is greater than a value no(k)P(k) that is obtained by multiplying an ordinary-ray refractive index no(k) by the helical pitch P (k). A relationship, ne(k - 1)P(k - 1) < no(k)P(k), is established between the selective reflection layers SR that form the selective reflection regions.

FIG. 2

**Description**

Technical Field

The present invention relates to a display device, and more particularly to a display device including a circular polarizer plate and self-luminous elements capable of achieving a high contrast.

Background Art

In recent years, an organic electroluminescence (EL) element, which is a typical self-luminous element capable of being included in a display device, has attracted special attention, since an organic light-emitting material that is applied to the organic EL element has been developed to a practical level and the organic EL element has such features as low power consumption, a wide viewing angle, small thickness and light weight.

A general organic EL element is configured such that a light-emission layer is sandwiched between a first electrode, which mainly has light reflectivity, and a second electrode, which mainly has light transmissivity. In the organic EL element with this structure, light that is produced by the light-emission layer is extracted from the second electrode side. Specifically, part of the light emitted from the light-emission layer emerges from the second electrode toward the viewer, and light that is emitted from the light-emission layer toward the first electrode is reflected by the first electrode toward the second electrode. In short, the first electrode has a function of guiding the emitted light as much as possible toward the viewer.

In the case of the organic EL element with this structure, however, the contrast characteristics would become lower as the reflectance of the first electrode that functions as the reflecting layer increases. Specifically, when external light is incident in a state in which the light-emission layer is caused to produce no light, that is, in a black display state, the first electrode reflects the external light and a black level in black display deteriorates. Besides, when external light is incident in a state in which the light-emitting layer is caused to produce light, such external light appears on the display screen and the contrast deteriorates.

Possible methods for solving this problem include a method in which the reflectance of the reflecting layer is lowered (extremely speaking, reduced to nearly zero), and a method in which a reflective component of external light is absorbed by a circular polarization plate. The latter method aims at improving the contrast on the basis of the following principle.

External light that is incident from the second electrode side of the organic EL element passes through a polarizer plate and a 1/4 wavelength plate and thus becomes, e.g. clockwise circularly polarized light. The clockwise circularly polarized light, if reflected by an interface of the substrate or the reflecting layer, has its phase displaced by 180° and becomes counterclockwise circularly polarized light. The counterclockwise circularly polarized light then passes through the 1/4 wavelength plate and becomes linearly polarized light in a direction perpendicular to the direction at the time of incidence. Thus, this linearly polarized light is parallel to the absorption axis of the polarizer plate and is absorbed by the polarizer plate.

Therefore, regardless of the reflectance of the reflecting layer, it is possible to obtain the same advantageous effect as in the case where the external light is not reflected. The same advantageous effect is obtained not only with respect to the reflection by the reflecting layer, but also with respect to dielectric reflection at the interface of the substrate or reflection at the wiring electrode. Thus, compared to the case where the polarizer plate and 1/4 wavelength plate are not provided, the contrast characteristics can be improved (see, e.g. Jpn. Pat. Appln. KOKAI Publication No. 9-127885).

However, light that is emitted from the light-emitting layer also includes clockwise polarized light and counterclockwise polarized light. Although the clockwise polarized light passes through the polarizer plate, the counterclockwise polarized light is absorbed by the polarizer plate. That is, at least 50% of the light that emanates from the light-emitting layer is absorbed by the polarizer plate. Consequently, the display luminance itself decreases. In the case of a currently practically used polarizer plate, the display luminance lowers by about 56%, compared to the case in which the polarizer plate and 1/4 wavelength plate are not provided.

As has been described above, in the self-luminous element such as an organic EL element, the reflecting layer, which is provided in order to efficiently extract the light that is produced by the light-emitting layer, causes deterioration in contrast characteristics. This problem is conspicuous in a light environment, that is, in a condition in which external light is intense. To cope with this problem, the polarizer plate and 1/4 wavelength plate may be provided. In this case, however, the contrast characteristics are improved but the display luminance decreases.

Disclosure of Invention

The present invention has been made in consideration of the above-described problems, and the object of the invention is to provide a display device that includes self-luminous elements and is capable of improving contrast characteristics and enhancing display luminance.

According to a first aspect of the present invention, there is provided a display device including a reflecting layer, a light-emitting layer, a 1/4 wavelength plate and a polarizer plate, the 1/4 wavelength plate being positioned between the polarizer plate and the light-emitting layer, and the light-emitting layer being positioned between the 1/4 wavelength plate and the reflecting layer, the display device comprising:

selective reflection layers that are disposed between the 1/4 wavelength plate and the light-emitting layer, include liquid crystal molecules that are aligned with a predetermined helical pitch, pass first circularly polarized light, and reflect second circularly polarized light that has a polarity opposite to a polarity of the first circular polarized light and has a predetermined wavelength,

wherein the light-emitting layer has at least one peak wavelength, and the selective reflection layers include an m-number of selective reflection regions when the number of peak wavelengths is m,

when a peak wavelength of light emerging from the light-emitting layer is $\lambda p(k)$ (k = 1, 2, ..., m in an order from a smallest wavelength), the peak wavelength $\lambda p(k)$ is less than a value $ne(k)P(k)$ that is obtained by multiplying an extraordinary-ray refractive index $ne(k)$ of the selective reflection layer that forms each selective reflection region by a helical pitch $P(k)$, and is greater than a value $no(k)P(k)$ that is obtained by multiplying an ordinary-ray refractive index $no(k)$ by the helical pitch $P(k)$, and

a relationship, $ne(k - 1)P(k - 1) < no(k)P(k)$, is established between the selective reflection layers that form the selective reflection regions.

According to a second aspect of the present invention, there is provided a display device including a reflecting layer, a light-emitting layer, a color filter, a 1/4 wavelength plate and a polarizer plate, the 1/4 wavelength plate being positioned between the polarizer plate and the color filter, and the color filter being positioned between the 1/4 wavelength plate and the light-emitting layer, the display device comprising:

selective reflection layers that are disposed between the 1/4 wavelength plate and the color filter, include liquid crystal molecules that are aligned with a predetermined helical pitch, pass first circularly polarized light, and reflect second circularly polarized light that has a polarity opposite to a polarity of the first circular polarized light and has a predetermined wavelength,

wherein light that is emitted from the light-emitting layer and transmitted through the color filter has at least one peak wavelength, and the selective reflection layers include an m-number of selective reflection regions when the number of peak wavelengths is m,

when a peak wavelength of light emerging from the color filter is $\lambda p(k)$ (k = 1, 2, ..., m in an order from a smallest wavelength), the peak wavelength $\lambda p(k)$ is less than a value $ne(k)P(k)$ that is obtained by multiplying an extraordinary-ray refractive index $ne(k)$ of the selective reflection layer that forms each selective reflection region by a helical pitch $P(k)$, and is greater than a value $no(k)P(k)$ that is obtained by multiplying an ordinary-ray refractive index $no(k)$ by the helical pitch $P(k)$, and

a relationship, $ne(k - 1)P(k - 1) < no(k)P(k)$, is established between the selective reflection layers that form the selective reflection regions.

Brief Description of Drawings

FIG. 1 is a perspective view that schematically shows the structure of an organic EL display device according to an embodiment of the present invention;

FIG. 2 is a cross-sectional view that schematically shows the structure of the organic EL display device shown in FIG. 1;

FIG. 3 is a graph that schematically shows a light-emission spectrum distribution in each pixel of the organic EL display device;

FIG. 4 schematically shows an example of the structure of a selective reflection layer in the organic EL display device shown in FIG. 2;

FIG. 5 is a view for explaining the relationship between the reflectance of a counterclockwise circularly polarized light component emitted from each pixel and the selective reflection function of the reflective reflection layer;

FIG. 6 is a view for explaining the optical function in a top-surface emission type display device;

FIG. 7 schematically shows the structure of a display device according to an embodiment of the invention;

FIG. 8 is a graph that shows a result of comparison in emission light transmittance between a display device without a selective reflection layer and a display device with a selective reflection layer;

FIG. 9 is a view for explaining an anti-reflection function in the display device with the selective reflection layer;

FIG. 10 schematically shows the structure of a display device according to another embodiment of the invention; and

FIG. 11 schematically shows the structure of a display device according to still another embodiment of the invention.

Best Mode for Carrying Out the Invention

A display device according to an embodiment of the present invention will now be described with reference to the accompanying drawings. In this embodiment, a self-luminous display device, such as an organic EL (electroluminescence) display device, is described, by way of example, as the display device.

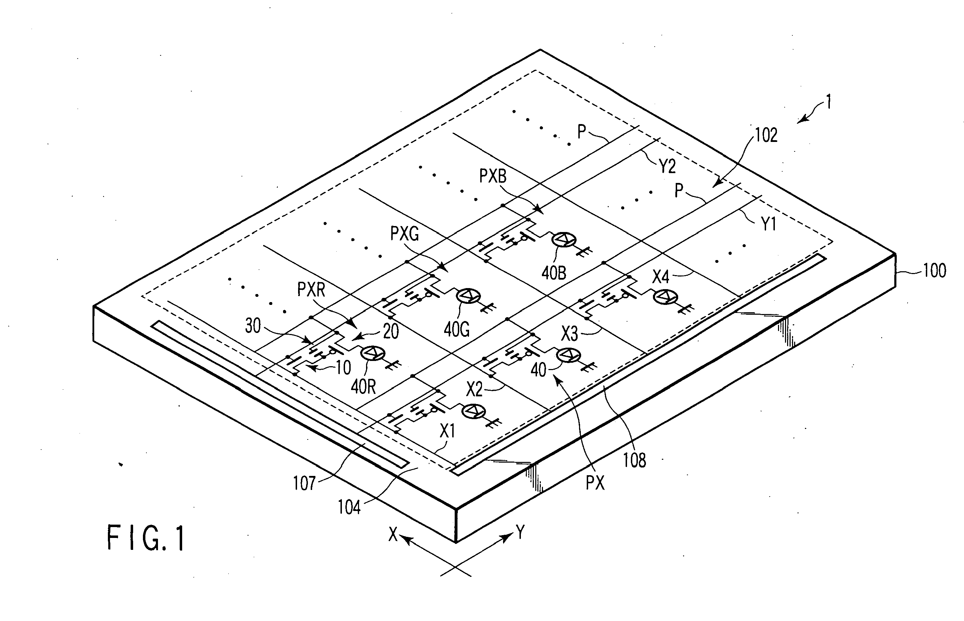

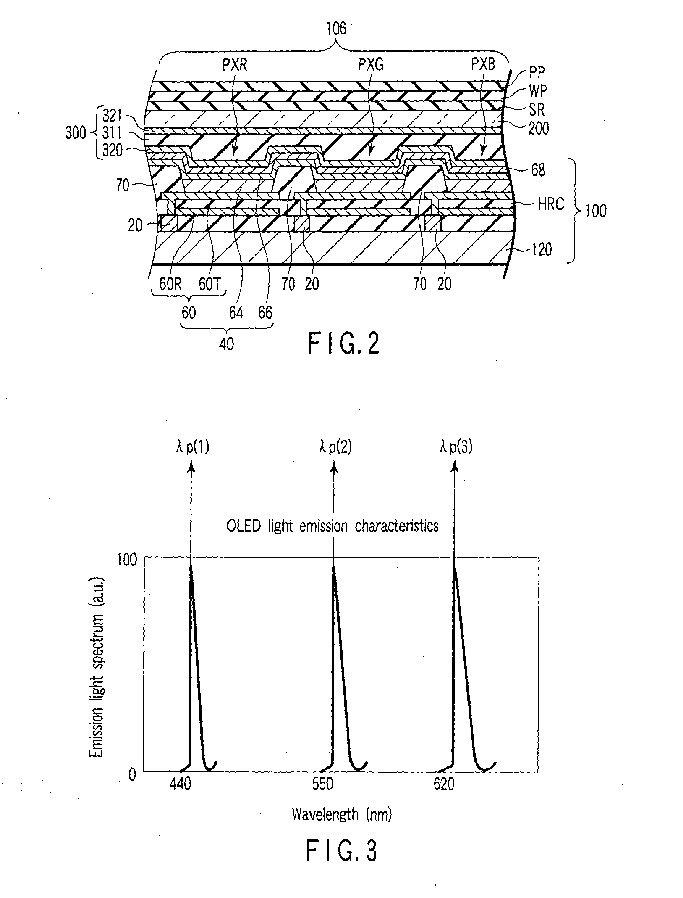

As is shown in FIG. 1 and FIG. 2, an organic EL display device 1 is configured to have an array substrate 100 having a display area 102 for displaying an image, and a sealing member 200 that seals at least the display area 102 of the array substrate 100. The display area 102 of the array substrate 100 comprises a plurality of pixels PX (R, G, B) that are arranged in a matrix.

Each of the pixels PX (R, G, B) includes a pixel switch 10 with a function of electrically separating an on-state pixel and an off-state pixel and retaining a video signal to the on-state pixel; a driving transistor 20 that supplies a desired driving current to an associated display element on the basis of the video signal that is supplied via the pixel switch 10; and a storage capacitance element 30 that stores a gate-source potential of the driving transistor 20 for a predetermined time period. Each of the pixel switch 10 and driving transistor 20 is composed of, e.g. a thin-film transistor, and includes a semiconductor layer, which is formed of polysilicon, in this embodiment.

Each of the pixels PX (R, G, B) includes an organic EL element 40 (R, G, B) functioning as a display element. Specifically, the red pixel PXR includes an organic EL element 40R that emits red light. The green pixel PXG includes an organic EL element 40G that emits green light. The blue pixel PXB includes an organic EL element 40B that emits blue light.

The respective organic EL elements 40 (R, G, B) have basically the same structure. The organic EL element 40 comprises an associated one of first electrodes 60 that are formed in an insular shape in the respective pixels PX and are arranged in a matrix; a second electrode 66 that is formed commonly to all the pixels PX so as to be opposed to the first electrodes 60; and an organic active layer 64 that is interposed between the first electrodes 60 and the second electrode 66.

The array substrate 100 includes a plurality of scan lines Ym (m = 1, 2, ...) that are arranged in a row direction (i.e. Y-direction in FIG. 1) of pixels PX, a plurality of signal lines Xn (n = 1, 2, ...) that are arranged in a direction (i.e. X-direction in FIG. 1) that crosses the scan lines Ym substantially at right angles, and power supply lines P for supplying power to the first electrodes 60 of the organic EL elements 40.

The power supply lines P are connected to a first electrode power supply line (not shown) that is disposed on the periphery of the display area 102. The second electrode 66 of the organic EL element 40 is connected to a second electrode power supply line (not shown) that is disposed on the periphery of the display area 102 and supplies a common potential (a ground potential in this example).

The array substrate 100 further includes a scan line drive circuit 107, which supplies scan signals to the scan lines Ym, and a signal line drive circuit 108, which supplies video signals to the signal lines Xn, in a peripheral area 104 that is provided around the outer periphery of the display area 102. All scan lines Ym are connected to the scan line drive circuit 107. All signal lines Xn are connected to the signal line drive circuit 108.

The pixel switches 10 are disposed near intersections between the scan lines Ym and signal lines Xn. The pixel switch 10 has a gate electrode connected to the scan line Ym, a source electrode connected to the signal line Xn, and a drain electrode connected to one of electrodes of the storage capacitance element 30 and to a gate electrode of the driving transistor 20. The driving transistor 20 has a source electrode connected to the other of the electrodes of the storage capacitance element 30 and to the power supply line P, and a drain electrode connected to the first electrode 60 of the organic EL element 40.

The array substrate 100, as shown in FIG. 2, includes the organic EL element 40, which is disposed on a wiring substrate 120. The wiring substrate 120 is configured such that the pixel switch 10, driving transistor 20, storage capacitance element 30, scan line drive circuit 107, signal line drive circuit 108 and various lines (e.g. scan lines, signal lines and power supply lines) are provided on an insulating support substrate such as a glass substrate or a plastic sheet.

The first electrode 60 that is a structural component of the organic EL element 40 is disposed on an insulating film of the wiring substrate 120. The first electrode 60 comprises a transmissive film 60T that mainly has light transmissivity, and a reflective film 60R that mainly has light reflectivity. The first electrode 60 functions as an anode. The transmissive film 60T is electrically connected to the driving transistor 20 and is formed of a light-transmissive electrically conductive material such as ITO (indium tin oxide) or IZO (indium zinc oxide). The reflective film 60R is disposed under the transmissive film 60T via an insulating layer HRC, that is, on the wiring substrate 120 side. The reflective film 60R is formed of, for instance, a multi-layer film of molybdenum (Mo)/aluminum (Al)/molybdenum (Mo). The reflective film 60R, like the transmissive film 60T, is electrically connected to the driving transistor 20. However, the reflective film 60R is not necessarily electrically connected to the driving transistor 20. In short, in the first electrode 60, it is the electrically conductive material of the transmissive film 60T that functions as the anode, and the reflective film 60R may be configured to reflect light with a predetermined wavelength, which is produced by the organic active layer 64. In addition, the first electrode 60 may be formed of a single layer. Specifically, in FIG. 2, the transmissive film 60T may be replaced with a material that has properties of an anode and light reflectivity. In this case, the reflective film 60R shown in FIG. 2 is dispensed with. An example of the material suitable for such a single-layer first electrode is Pt.

The organic active layer 64 includes at least an organic compound with a light-emitting function. The organic active layer 64 may be constructed of a multi-layer structure that includes a hole buffer layer and an electron buffer layer, which are formed commonly to all color pixels, and a light-emitting layer, which is formed for each of the color pixels. Alternatively, the organic active layer 64 may be constructed of two layers or a single layer in which functions of various layers are integrated. The hole buffer layer is interposed between the anode and the organic light-emitting layer, and is formed of a thin film of, e.g. an aromatic amine derivative, a polythiophene derivative or a polyaniline derivative. The light-emitting layer is formed of an organic compound with a function of emitting red, green or blue light. When a high-polymer light emitting material is used, the light-emitting layer is formed of PPV (polyparaphenylenevinylene), or a polyfluorene derivative or a precursor thereof.

The second electrode 66 is disposed on the organic active layer 64 commonly to all the organic EL elements 40. The second electrode 66 is formed of a metallic film that mainly has light transmissivity, and functions as a cathode. In this example, the second electrode 66 is formed of a metallic film with an electron injection function such as Ca (calcium), Al (aluminum), Ba (barium), Ag (silver) or Yb (ytterbium). The second electrode 66 may be a two-layer structure in which the surface of a metal film functioning as a cathode is coated with a cover metal. The cover metal is formed of, e.g. aluminum.

It is preferable that the surface of the second electrode 66 be coated with a material having moisture-absorbing characteristics as a desiccating agent. If the organic EL element 40 comes in contact with moisture, its light-emission characteristics would deteriorate very quickly. Thus, in order to protect the organic EL element 40 from moisture, a desiccating agent 68 is disposed on the second electrode 66 that corresponds to the surface of the organic EL element 40. The desiccating agent 68 may be formed of any material with moisture-absorbing characteristics. Examples of the material of the desiccating agent 68 are a simple-substance alkali metal such as lithium (Li), sodium (Na) or potassium (K) or an oxide thereof, and an alkali earth metal such as magnesium (Mg), calcium (Ca) or barium (Ba) or an oxide thereof.

The array substrate 100 includes partition walls 70 that separate at least neighboring color pixels RX (R, G, B) in the display area 102. It is preferable that the partition walls 70 be formed so as to separate the pixels. In this example, the partition walls 70 are arranged in a lattice shape along the peripheral edges of the first electrodes 60 so that the opening defined by the partition walls 70, where the first electrode 60 is exposed, may have a circular or polygonal shape.

The array substrate 100 includes a sealing body 300 that is disposed to cover at least an effective region 106 of one of the major surfaces of the wiring substrate 120. In this example, it is assumed that the effective region 106 includes at least the display area 102 having pixels PX (R, G, B) for displaying an image. Alternatively, the effective region 106 may include the peripheral area 104 including the scan line drive circuit 107 and signal line drive circuit 108. The surface of the sealing body 300 is substantially planarized.

The sealing member 200 is attached to the surface of the sealing body 300 by an adhesive that is coated on the entire surface of the sealing body 300. The sealing member 200 is formed of, e.g. a light-transmissive insulating film such as a plastic sheet, or diamond-like carbon.

The sealing body 300 has a stacked structure that comprises at least one buffer layer 311, and at least two barrier layers 320 and 321 each having a pattern with a larger area than the buffer layer and covering the buffer layer so as to shield the buffer layer from outside air. In the example, the sealing body 300 includes a first barrier layer 320, a buffer layer 311 that is disposed on the first barrier layer 320 so as to correspond to the effective region 106, and a second barrier layer 321 that covers the entirety of the buffer layer 311 including its side surfaces.

The buffer layer 311 is formed of an organic material such as an acrylic resin material. The buffer layer 311 is formed with a thickness of about 0.1 to 2 $\mu$m. In particular, as the material of the buffer layer 311, it is preferable to select a material that can be coated in a liquid state with a relatively low viscosity and can be solidified in such a state as to planarize irregularities on the underlying layer. The buffer layer 311 that is formed of such a material functions as a planarizing layer that planarizes the surface of the underlying layer.

Each barrier layer 320, 321 is formed of an inorganic material. For example, each barrier layer 320, 321 is formed of a metal material such as aluminum or titanium, a metal oxide material such as ITO or IZO, or a ceramic material such as alumina, with a thickness on the order of, e.g. 0.1 $\mu$m. In the case of a back-face emission type in which EL light is extracted from the first electrode 60 side, the material that is used for at least one of the barrier layers 320, 321 should preferably have light-blocking properties and reflectivity. In the case of a top-face emission type in which EL light is extracted from the second electrode 66 side, the material that is used for the barrier layers 320, 321 should preferably have light transmissivity.

In the organic EL device 40 with the above-described structure, electrons and holes are injected in the organic active layer 64 sandwiched between the first electrode 60 and second electrode 66. The electron and hole are recombined to form an exciton, and light is produced by photo-emission of a predetermined wavelength which occurs when the exciton is deactivated. Specifically, in the organic EL elements 40 that constitute the respective pixels PX (R, G, B), the associated organic active layers (light-emitting layers) 64 emit EL lights with different single-peak wavelengths. For example, in the case where three kinds of pixels constitute 1 pixel unit, color display and black-and-white display can be effected by the red pixel PXR having a red peak wavelength (near 620 nm), the green pixel PXG having a green peak wavelength (near 550 nm) and the blue pixel PXB having a blue peak wavelength (near 440 nm).

In the top-surface emission type display device with the above-described structure, EL light that is produced by the light-emitting layer of the organic active layer 64 is emitted from the upper surface side of the array substrate 100, that is, from the second electrode 66 side. EL light that is emitted toward the first electrode 60 is reflected by the reflective film 60R and emerges from the second electrode 66.

In the above-described top-surface emission type display device, a selective reflection layer SR, a 1/4 wavelength plate WP and a polarizer plate PP are stacked in the name order on the EL light emission surface, that is, on the sealing member 200. In the example shown in FIG. 2, the 1/4 wavelength plate WP is interposed between the polarizer plate PP and the organic active layer (light-emitting layer) 64. In addition, the organic active layer 64 interposed between the 1/4 wavelength plate WP and the reflective film 60R.

The selective reflection layer SR includes liquid crystal molecules that are aligned with a predetermined helical pitch, and has a function of passing first circularly polarized light (e.g. clockwise circularly polarized light) and reflecting second circularly polarized light (e.g. counterclockwise circularly polarized light) having a polarity opposite to the polarity of the first circularly polarized light and a predetermined wavelength. The selective reflection layer SR is configured to include an m-number of selective reflection regions when the number of peak wavelengths of EL lights emitted from the organic active layers 64 is m.

In the present embodiment, in the case where 1 pixel unit is composed by arraying three kinds of pixels, i.e. red pixel PXR, green pixel PXG and blue pixel PXB, in a planar fashion, the organic active layers 64 of the organic EL elements 40 that are provided in the respective pixels PX (R, G, B) emit EL lights with single-peak wavelengths. Thus, the number m of peak wavelengths is 3. For example, as shown in FIG. 3, EL light that is emitted from the organic active layer 64 of the blue pixel PXB has a single first peak wavelength $\lambda p(1)$ near 440 nm. EL light that is emitted from the organic active layer 64 of the green pixel PXG has a single second peak wavelength $\lambda p(2)$ near 550 nm. EL light that is emitted from the organic active layer 64 of the red pixel PXR has a single third peak wavelength $\lambda p(3)$ near 620 nm. In short, the peak wavelengths of lights emitted from the respective organic active layers 64 are $\lambda p(1)$, $\lambda p(2)$ and $\lambda p(3)$ in the order from the smallest one.

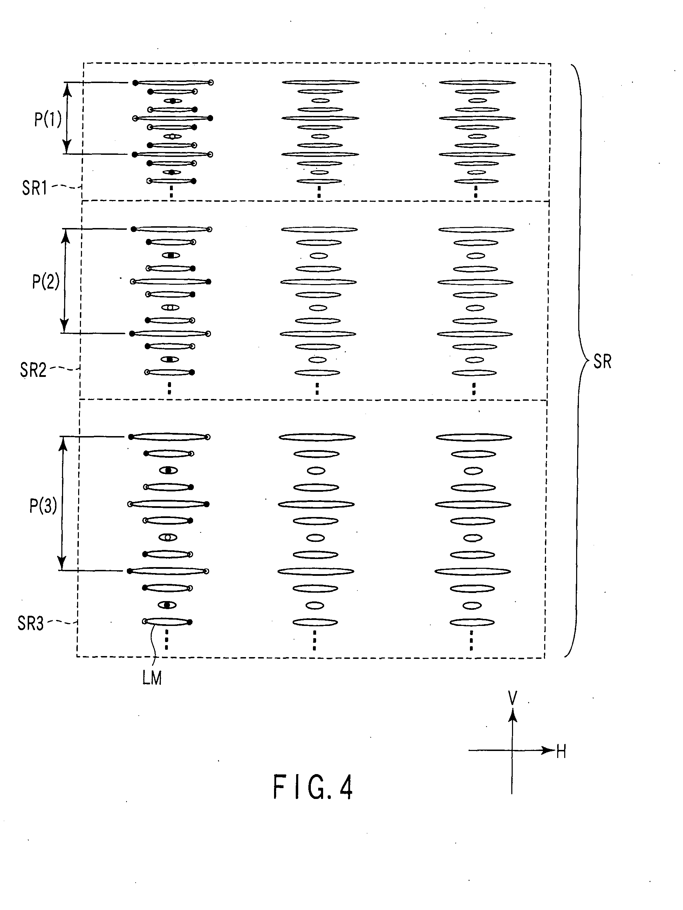

In the present embodiment, the selective reflection layer SR is configured to have three selective reflection wavelength regions. Specifically, as shown in FIG. 4, the selective reflection layer SR includes a first reflection layer SR1, a second reflection layer SR2 and a third reflection layer SR3.

The first reflection layer SR1 includes liquid crystal molecules that are aligned with a first helical pitch P(1) corresponding to the first peak wavelength $\lambda p(1)$. The first reflection layer SR1 passes the first circularly polarized light and reflects the second circularly polarized light having a predetermined wavelength including the first peak wavelength $\lambda p(1)$ with a polarity opposite to the polarity of the first circularly polarized light.

The second reflection layer SR2 includes liquid crystal molecules that are aligned with a second helical pitch P(2) corresponding to the second peak wavelength $\lambda p(2)$. The second reflection layer SR2 passes the first circularly polarized light and reflects the second circularly polarized light having a predetermined wavelength including the second peak wavelength $\lambda p(2)$ with a polarity opposite to the polarity of the first circularly polarized light. The second helical pitch P(2) is set to be greater than the first helical pitch P(1).

The third reflection layer SR3 includes liquid crystal molecules that are aligned with a third helical pitch P(3) corresponding to the third peak wavelength $\lambda p(3)$. The third reflection layer SR3 passes the first circularly polarized light and reflects the second circularly polarized light having a predetermined wavelength including the third peak wavelength $\lambda p(3)$ with a polarity opposite to the polarity of the first circularly polarized light. The third helical pitch P(3) is set to be greater than the second helical pitch P(2).

The respective reflection layers SR (1, 2, 3) are configured to include cholesteric liquid crystal layers with different helical pitches. In each reflection layer SR (1, 2, 3), as shown in FIG. 4, liquid crystal molecules (generally, nematic liquid crystal molecules) LM are aligned in a direction parallel to a horizontal plane (major plane of each reflection layer) H, and are twisted in a normal direction (thickness direction perpendicular to the major plane of each reflection layer). The helical pitch of each reflection layer SR (1, 2, 3) corresponds to the length in the normal direction V of each reflection layer, which is needed for one rotation of the liquid crystal molecules LM in the horizontal plane. In this example, the helical pitches are P(1), P(2) and P(3) in the order from the smallest one.

Preferably, each reflection layer SR (1, 2, 3) should be formed of one of a cholesteric liquid crystal layer, a layer obtained by polymerizing a cholesteric liquid crystal layer, and a layer obtained by forming a cholesteric liquid crystal layer in a film shape. In the case of the example shown in FIG. 2, the selective reflection layer SR may be formed by directly stacking a plurality of reflection layers SR (1, 2, 3) in succession on the sealing member 200 or 1/4 wavelength plate WP. Alternatively, the selective reflection layer SR may be formed by stacking a plurality of reflection layers SR (1, 2, 3) on a base film such as a polyimide resin film, following which the selective reflection layer SR may be attached to the sealing member 200 or 1/4 wavelength plate WP. In a case where the selective reflection layer SR has a sufficient shield performance against outside air (i.e. against moisture or oxygen), the selective reflection layer SR may double as the sealing member 200 and may be disposed on the sealing body 300, or the selective reflection layer SR may double as the sealing body 300 and may be directly disposed on the organic EL element 40.

The helical pitch of each reflection layer SR (1, 2, 3) is controllable by selecting an optimal combination of kinds of chiral materials for orienting liquid crystal material or liquid crystal molecules. Even in the case where the same chiral material is used, the helical pitch is controllable by adjusting the concentration of the chiral material (the higher the concentration, the less the helical pitch).

As is shown in .FIG. 3, there are three emission light peak wavelengths in red, green and blue. When the three wavelengths are $\lambda p(1)$, $\lambda p(2)$ and $\lambda p(3)$ in the order from the smallest one, a value $no(1)P(1)$, which is obtained by multiplying an ordinary-ray refractive index $no(1)$ of the selective reflection layer SR (in particular, the first reflection layer SR1) in the vicinity of the wavelength $\lambda p(1)$ by the helical pitch $P(1)$ of the selective reflection layer SR (in particular, the first reflection layer SR1), and a value $ne(1)P(1)$, which is obtained by multiplying an extraordinary-ray refractive index $ne(1)$ by the helical pitch $P(1)$, are set to meet the following relationship with respect to the peak wavelength $\lambda p(1)$:

$$no(1)P(1) < \lambda p(1) < ne(1)P(1).$$

Similarly, a value $no(2) P(2)$, which is obtained by multiplying an ordinary-ray refractive index $no(2)$ of the selective reflection layer SR (in particular, the second reflection layer SR2) in the vicinity of the wavelength $\lambda p(2)$ by the helical pitch $P(2)$ of the selective reflection layer SR (in particular, the second reflection layer SR2), and a value $ne(2)P(2)$, which is obtained by multiplying an extraordinary-ray refractive index $ne(2)$ by the helical pitch $P(2)$, are set to meet the following relationship with respect to the peak wavelength $\lambda p(2)$:

$$no(2)P(2) < \lambda p(2) < ne(2)P(2).$$

In like manner, a value $no(3)P(3)$, which is obtained by multiplying an ordinary-ray refractive index $no(3)$ of the selective reflection layer SR (in particular, the third reflection layer SR3) in the vicinity of the wavelength $\lambda p(3)$ by the helical pitch $P(3)$ of the selective reflection layer SR (in particular, the third reflection layer SR3), and a value $ne(3)P(3)$, which is obtained by multiplying an extraordinary-ray refractive index $ne(3)$ by the helical pitch $P(3)$, are set to meet the following relationship with respect to the peak wavelength $\lambda p(3)$:

$$no(3)P(3) < \lambda p(3) < ne(3)P(3).$$

At the same time, the reflection layers SR (1, 2, 3) including the individual selective reflection wavelength regions, which constitute the selective reflection layer SR, are set to have the helical pitches $P(1)$, $P(2)$ and $P(3)$, which meet the relationships, $ne(1)P(1) < no(2)P(2)$, and $ne(2)P(2) < no(3)P(3)$.

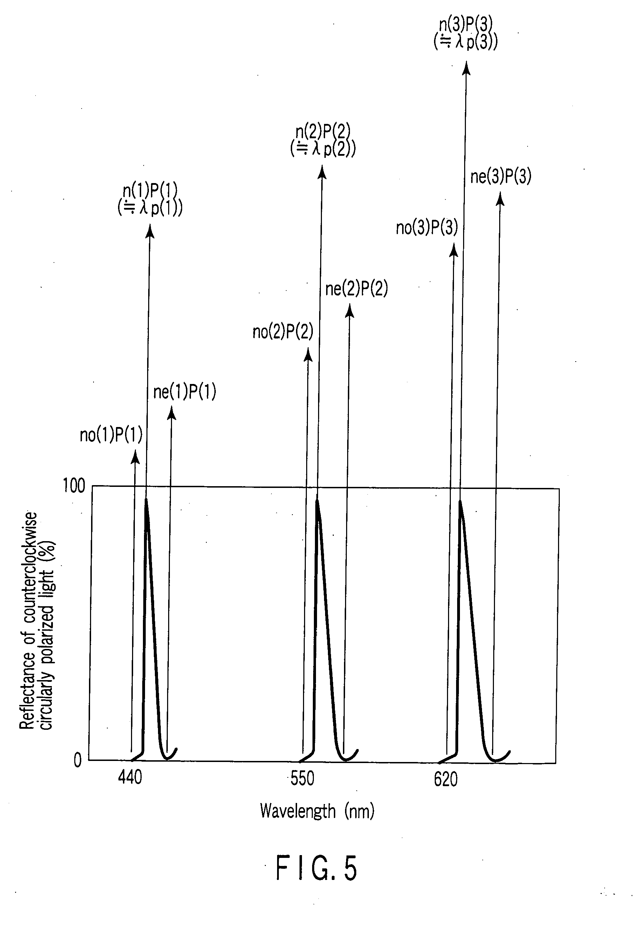

The selective reflection layer SR with this structure has a wavelength dispersion of reflectance, as shown in FIG. 5, with respect to circular polarized light in the same rotational direction as the direction of helix of the liquid crystal molecules LM in the selective reflection layer SR. FIG. 5 shows a wavelength dispersion of reflectance with respect to counterclockwise circular polarized light in the case where the direction of helix in the selective reflection layer SR is counterclockwise. As is shown in FIG. 3 and FIG. 5, the selective reflection layer SR has the function of reflecting only an emission light spectrum of EL light (i.e. light of a predetermined wavelength including a peak wavelength) emitted from the organic active layer 64, which is included in the circular polarized light in the same rotational direction as the direction of helix of the liquid crystal molecules LM in the selective reflection layer SR.

As is shown in FIG. 5, it is preferable that a value $n(k)P(k)$, which is obtained by multiplying a mean refractive index $n(k)$ ($= (\{ne(k)^2 + no(k)^2\}/2)^{1/2}$; extraordinary-ray wavelength $\lambda e >$ ordinary-ray wavelength $\lambda o$) of the selective reflection layers SR (1, 2, 3) of the selective reflection layer SR by the helical pitch $P(k)$, be set to be substantially equal to a peak wavelength $\lambda p(k)$. By this setting, the emission light spectrum and the wavelength dispersion of reflectance of the selective reflection layer agree more exactly and the above-described advantageous effect is enhanced.

It is desirable that the reflectance of the second circular polarized light, which is reflected by the selective reflectance layer, be set at 50% or more at the peak wavelength $\lambda p(k)$. By this setting, the luminance of each EL element 40 becomes higher by 50% or more than that in a conventional element without a selective reflectance layer, and sufficient luminance characteristics can be obtained.

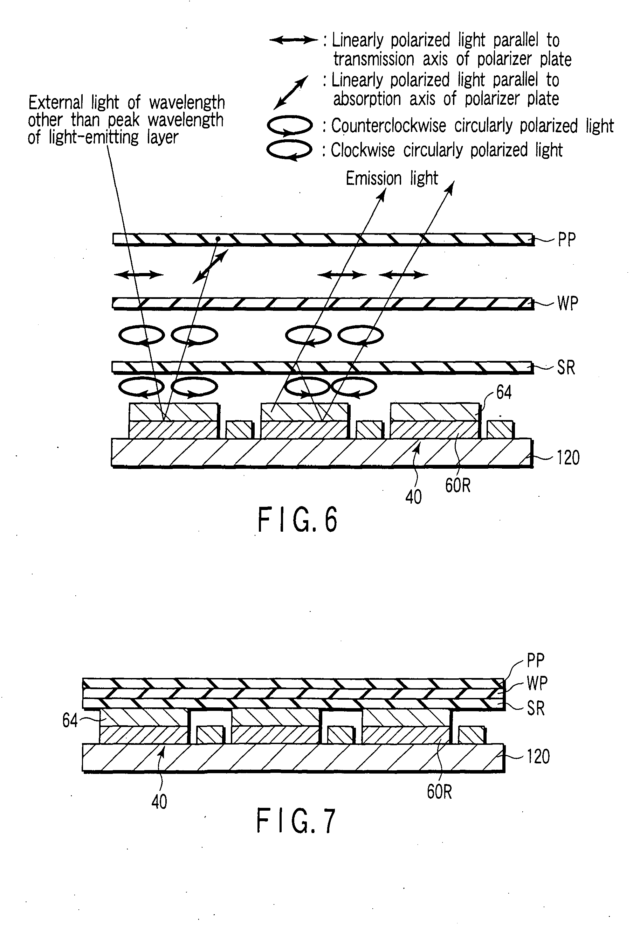

Next, referring to FIG. 6, the optical function in the above-described top-surface emission type display device is explained. For the purpose of simplicity, FIG. 6 depicts, by way of example, only the polarizer plate PP, 1/4 wavelength plate WP, selective reflection layer SR, organic active layer (light-emitting layer) 64, reflective film 60R, and wiring substrate 120 provided with organic active layer (light-emitting layer 64, which are arranged in the named order. In addition, for the purpose of convenience, different optical paths are depicted for external light, which enters the display device from outside, and light that is emitted from the organic active layer 64.

The polarizer plate PP has, in its plane, an absorption axis and a transmission axis in different directions. The 1/4 wavelength plate WP imparts a 1/4 wavelength phase difference between an ordinary ray and an extraordinary ray of light of a predetermined wavelength. The optical axes of the polarizer plate PP and 1/4 wavelength plate WP are so set that incident external light (non-polarized light) may become substantially circularly polarized light, for instance, clockwise circularly polarized light.

Thereby, external light (non-polarized light) that is incident on the display device passes through the polarizer plate PP and 1/4 wavelength plate WP and becomes clockwise circularly polarized light. Since the liquid crystal molecules of the selective reflection layer SR are twisted counterclockwise, the circularly polarized light that emerges from the 1/4 wavelength plate WP is not reflected and passes while maintaining its polarization state. Thus, the incident light becomes clockwise circularly polarized light regardless of the wavelength, and passes through the organic active layer 64 and is reflected by the reflective film 60R.

The reflective light that is reflected by the reflective film 60R has its phase shifted by 180°, and becomes counterclockwise circularly polarized light. Of the counterclockwise circularly polarized light, the selective reflection layer SR reflects a counterclockwise circularly polarized light component having a predetermined wavelength corresponding to the helical pitch (i.e. a predetermined wavelength including a peak wavelength of emission light from the organic active layer 64) but passes a counterclockwise circularly polarized light component having other wavelengths. Thus, most of the reflective light passes through the selective reflection layer SR as counterclockwise circularly polarized light with no change.

The transmissive light that emerges from the selective reflection layer SR is converted through the 1/4 wavelength plate WP to linearly polarized light that is parallel to the absorption axis of the polarizer plate PP, and the linearly polarized light is absorbed by the polarizer plate PP. Thus, even if most of the external light is reflected by the reflective film 60R, it is absorbed by the polarizer plate PP. Therefore, a sufficient anti-reflection function can be obtained.

By contrast, emission lights from the organic active layers 64 of the three kinds of pixels are non-polarized lights with peak wavelengths $\lambda p(1)$, $\lambda p(2)$ and $\lambda p(3)$. If the emission light is separated into components, it can be classified into counterclockwise circularly polarized light and clockwise circularly polarized light. Of the emission lights with peak wavelengths $\lambda p(1)$, $\lambda p(2)$ and $\lambda p(3)$, the clockwise circularly polarized light passes through the selective polarization layer SR. On the other hand, a counterclockwise circularly polarized light component of the emission light having the peak wavelength $\lambda p(1)$ is reflected by the first reflection layer SR1 toward the reflective film 60R as counterclockwise circularly polarized light since the first reflection layer SR1 has the function of selective reflection. Similarly, a counterclockwise circularly polarized light component of the emission light having the peak wavelength $\lambda p(2)$ is reflected by the second reflection layer SR2 toward the reflective film 60R as counterclockwise circularly polarized light since the second reflection layer SR2 has the function of selective reflection. In like fashion, a counterclockwise circularly polarized light component of the emission light having the peak wavelength $\lambda p(3)$ is reflected by the third reflection layer SR3 toward the reflective film 60R as counterclockwise circularly polarized light since the third reflection layer SR3 has the function of selective reflection.

The counterclockwise circularly polarized light that is reflected by the selective reflection layer SR is reflected once again by the reflective film 60R toward the selective reflective layer SR. The reflective light that is reflected by the reflective film 60R has its phase shifted by 180° and becomes clockwise circularly polarized light. Thus, the clockwise circularly polarized light passes through the selective reflection layer SR, like the clockwise circularly polarized light component of the emission light with the peak wavelengths $\lambda p(1)$, $\lambda p(2)$ and $\lambda p(3)$. As a result, all the emission light from the organic active layers 64 becomes clockwise circularly polarized light and passes through the selective reflection layer SR.

The clockwise circularly polarized light that emerges from the selective reflection layer SR is converted through the 1/4 wavelength plate WP to linearly polarized light that is parallel to the transmission axis of the polarizer plate PP, and the linearly polarized light passes through the polarizer plate PP. Thus, all the emission light from the organic active layers 64 is transmitted through the polarizer plate PP, and contributes to display.

According to the above-described display device, the anti-reflection function is implemented with respect to most of wavelengths of the incident external light. Moreover, although the polarizer plate is used, most of the emission light from the organic EL elements passes through the polarizer plate. Therefore, both excellent contract characteristics and a high display luminance can be achieved. According to this embodiment, a display device with excellent contract characteristics and high display luminance can be obtained.

(Embodiments)

As is shown in FIG. 7, an organic EL element 40 including a reflective film 60R and an organic active layer 64 was disposed on a wiring substrate 120 and sealed. Then, a selective reflection layer SR, a 1/4 wavelength plate WP and a polarizer plate PP were successively disposed from the organic active layer 64 side, and thus a display device was fabricated. For the purpose of simplicity, FIG. 7 depicts only the polarizer plate PP, 1/4 wavelength plate WP, selective reflection layer SR, organic active layer (light-emitting layer) 64, reflective film 60R and wiring substrate 120 provided with the organic active layer (light-emitting layer) 64. Depiction of other structural elements is omitted.

The selective reflection layer SR was formed such that a cholesteric liquid crystal polymer (manufactured by BASF) functioning as a first reflection layer, a cholesteric liquid crystal polymer (manufactured by BASF) functioning as a second reflection layer and a cholesteric liquid crystal polymer (manufactured by BASF) functioning as a third reflection layer were stacked with planar orientation. The cholesteric liquid crystal polymer of the first reflection layer has a helical pitch of 275 nm, and an ordinary-ray refractive index of 1.53 and an extraordinary-ray refractive index of 1.65 at a wavelength of 440 nm. The cholesteric liquid crystal polymer of the second reflection layer has a helical pitch of 350 nm, and an ordinary-ray refractive index of 1.52 and an extraordinary-ray refractive index of 1.62 at a wavelength of 550 nm. The cholesteric liquid crystal polymer of the third reflection layer has a helical pitch of 400 nm, and an ordinary-ray refractive index of 1.51 and an extraordinary-ray refractive index of 1.61 at a wavelength of 620 nm.

The thickness of each reflection layer is set at about 10 times the helical pitch of liquid crystal molecules (i.e. the thickness in the state in which liquid crystal molecules are rotated 10 times, if 1 pitch corresponds to 1 rotation of liquid crystal molecules). Values, which are obtained by multiplying the helical pitches by the mean refractive indices in the respective reflection layers, are set to effectively coincide with the three peak wavelengths $\lambda p(1)$, $\lambda p(2)$ and $\lambda p(3)$ of the organic active layers. Thereby, each reflection layer reflects circularly polarized light in the same direction as the direction of twist, e.g. counterclockwise circularly polarized light, which is included in the light of the wavelength corresponding to the value that is obtained by multiplying the helical pitch by the mean refractive index. The reflectance of each reflection layer varies depending on the film thickness, and is about 100% at a film thickness corresponding to about 10 times the helical pitch.

Thus, each reflection layer reflects light of a bandwidth of the counterclockwise circularly polarized light, the bandwidth corresponding to a value obtained by multiplying a difference $\Delta n$ between the ordinary-ray refractive index and extraordinary refractive index by the helical pitch, with a central wavelength of light being set at a value that is obtained by multiplying the helical pitch by the means refractive index. As mentioned above, the three kinds of reflection layers with different helical pitches are formed to have film thicknesses at which the reflectance of counterclockwise circularly polarized light is 100%, and each layer is able to reflect light of a bandwidth corresponding to the value obtained by multiplying $\Delta n$ by the helical pitch. Therefore, each layer has the function of selectively reflecting counterclockwise circularly polarized light in a wavelength region that is substantially equal to the bandwidth of emission light.

Preferably, the liquid crystal polymer layer that is used in this example should be one that can be handled as a film-like polymer or a thin-layer polymer. For example, the liquid crystal polymer layer may include an ultraviolet-curing resin, and may be cured by a cross-linking reaction that occurs due to ultraviolet irradiation. Alternatively, the liquid crystal polymer layer may include a thermosetting resin and may be cured by thermal polymerization due to heat. Although the selective reflection layer SR comprises the above-described stack of three kinds of reflection layers with different pitches, the same function and effect can be obtained even in the case where the selective reflection layer SR is formed of a layer having continuously varying helical pitches. In addition, the optical effect is unchanged even if the selective reflection layer SR is formed as a liquid crystal layer by using two or more substrates, without using the liquid crystal polymer.

Subsequently, a first phase plate (manufactured by NITTO DENKO CORPORATION) of ARTON resin with a retardation value of 140 nm was attached to the above-described selective reflection layer SR with an angle of 125° to the longitudinal direction of the device (the angle is defined in a counterclockwise direction; the same applies hereinafter). A second phase plate (manufactured by NITTO DENKO CORPORATION) of ARTON resin with a retardation value of 270 nm was attached to the first phase plate with an angle of 62.5° to the longitudinal direction of the device.

Thereafter, a polarizer plate SEG1224DUAGAR (manufactured by NITTO DENKO CORPORATION) was attached to the second phase plate with an angle of 45° to the longitudinal direction of the device. By attaching the first phase plate, second phase plate and polarizer plate with the above-described angular configuration, the two phase plates function as the 1/4 wavelength plate WP with respect to all wavelengths of visible light, and the structure including the polarizer plate PP functions as a counterclockwise circular polarizer. Thus, a display device, which has both the function of preventing reflection of external light and the function of emitting most of produced light, was successfully obtained.

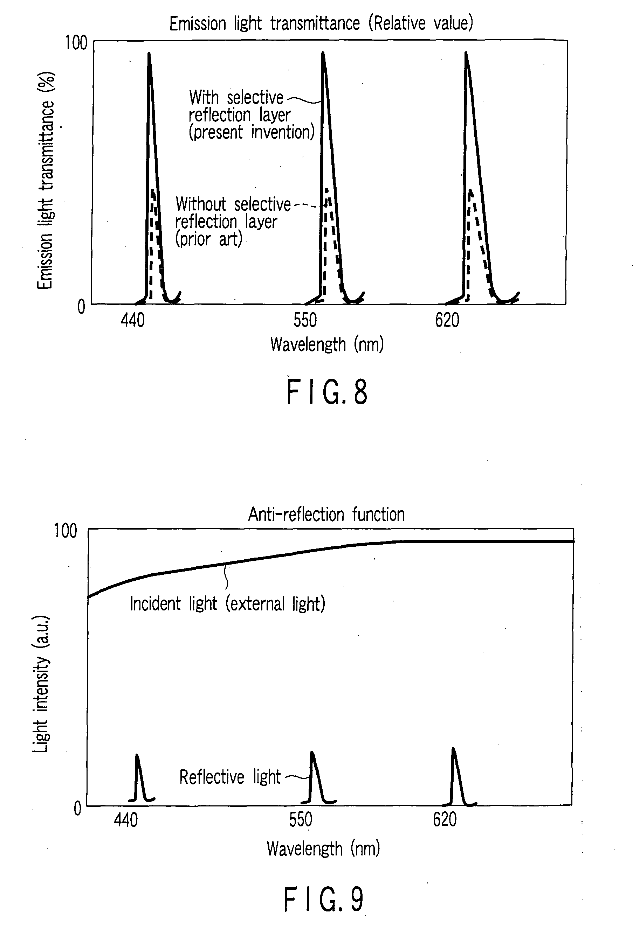

FIG. 8 shows a result of comparison in transmittance of emission light, which emerges from the polarizer plate, between the structure of a prior-art display device without a selective reflection layer and the structure of the present embodiment. As is shown in FIG. 8, it was confirmed that about double the transmittance of the prior-art display device was obtained with the display device of the present embodiment. FIG. 9 shows the anti-reflection function in the display device of the present embodiment, that is, the wavelength dispersion of reflectance of the display device of this embodiment with respect to the external light spectrum. As is shown in FIG. 9, it was confirmed that the reflection of light was small and a sufficient anti-reflection effect was obtained. Hence, it is understood that both high contract characteristics and high display luminance were obtained with the structure of the present embodiment.

The present invention is not limited to the above-described embodiments. At the stage of practicing the invention, various embodiments may be made by modifying the structural elements without departing from the spirit of the invention. Structural elements disclosed in the embodiments may properly be combined, and various inventions may be made. For example, some structural elements may be omitted from the embodiments. Moreover, structural elements in different embodiments may properly be combined.

In the above-described embodiment, the top-surface emission type display device is configured such that the red pixel PXR includes the organic EL element 40R that emits red light, the green pixel PXG includes the organic EL element 40G that emits green light, and the blue pixel PXB includes the organic EL element 40B that emits blue light. The present invention, however, is not limited to this embodiment.

For example, the respective pixels PX (R, G, B) may have the same kind of organic EL elements 40, and each organic EL element 40 may include an organic active layer that emits white light. In the case of this structure, the respective pixels PX (R, G, B) include a red color filter, a green color filter and a blue color filter on their EL light emission surfaces, thereby realizing color display. That is, the organic active layer that functions as the light emission layer emits light with no definite peak wavelength. The mission light is provided with a predetermined peak wavelength when it passes through the color filter.

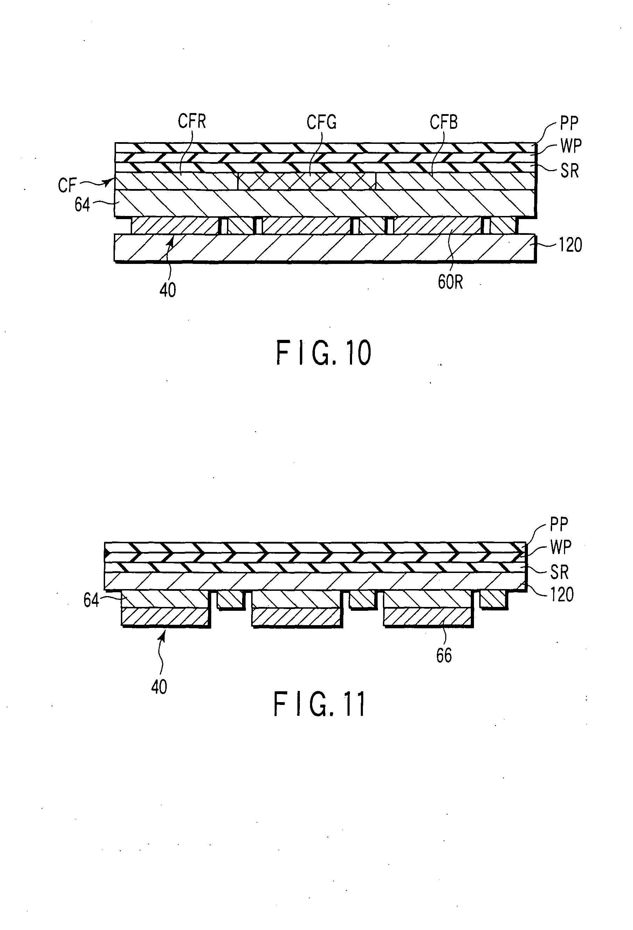

Specifically, as show in FIG. 10, an organic EL element 40 including a reflective film 60R and an organic active layer 64 was disposed on a wiring substrate 120 and sealed. Then, color filters CF, a selective reflection layer SR, a 1/4 wavelength plate WP and a polarizer plate PP were successively disposed from the organic active layer 64 side, and thus a display device was fabricated. The 1/4 wavelength plate WP is positioned between the polarizer plate PP and color filters CF, and the color filters CF are positioned between the 1/4 wavelength plate WP and organic active layer (light-emitting layer) 64. For the purpose of simplicity, FIG. 10 depicts only the polarizer plate PP, 1/4 wavelength plate WP, selective reflection layer SR, color filters CF, organic active layer (light-emitting layer) 64, reflective film 60R and wiring substrate 120 provided with the organic active layer (light-emitting layer) 64. Depiction of other structural elements is omitted.

For example, as the color filters CF, the red pixel includes a red color filter CFR (with a peak transmittance at, e.g. 620 nm), the green pixel includes a green color filter CFG (with a peak transmittance at, e.g. 550 nm), and the blue pixel includes a blue color filter CFB (with a peak transmittance at, e.g. 440 nm).

With this structure, too, the light that emerges from the organic active layer 64 and color filters CF is subjected to the same setting as in the above-described embodiment. Thereby, based on the same principle, it is possible to obtain the above-described function of preventing reflection of external light and the function of preventing absorption of emission light from the color filters in the polarizer plate.

Specifically, the selective reflection layer SR includes liquid crystal molecules that are aligned with a predetermined helical pitch, and has a function of passing first circularly polarized light (e.g. clockwise circularly polarized light) and reflecting second circularly polarized light (e.g. counterclockwise circularly polarized light) having a polarity opposite to the polarity of the first circularly polarized light and a predetermined wavelength. The selective reflection layer SR is configured to include an m-number of selective reflection regions when the number of peak wavelengths of light, which is emitted from the organic active layers 64 and is transmitted through the color filters CR, is m.

In this example of the structure, white EL emission lights, which are emitted from the organic active layers 64 of the organic EL elements 40 provided in the respective pixels PX (R, G, B), pass through the associated color filters and have single peak wavelengths. Thus, the number m of peak wavelengths is 3. For example, light that is emitted from the color filter CFB of the blue pixel PXB has a single first peak wavelength $\lambda p(1)$ near 440 nm. Light that is emitted from the color filter CFG of the green pixel PXG has a single second peak wavelength $\lambda p(2)$ near 550 nm. Light that is emitted from the color filter CFR of the red pixel PXR has a single third peak wavelength $\lambda p(3)$ near 620 nm. In short, the peak wavelengths of lights, which are emitted from the organic active layers 64 and transmitted through the respective color filters CF, are $\lambda p(1)$, $\lambda p(2)$ and $\lambda p(3)$ in the order from the smallest one.

Thus, the selective reflection layer SR is configured to have three selective reflection wavelength regions. Specifically, the selective reflection layer SR includes a first reflection layer SR1 that reflects counterclockwise circularly polarized light of the light with the first peak wavelength $\lambda p(1)$, a second reflection layer SR2 that reflects counterclockwise circularly polarized light of the light with the second peak wavelength $\lambda p(2)$, and a third reflection layer SR3 that reflects counterclockwise circularly polarized light of the light with the third peak wavelength $\lambda p(3)$.

The lights that emerge from the color filters have three peak wavelengths in red, green and blue. When the three wavelengths are λp(1), λp(2) and λp(3) in the order from the smallest one, a value no(1) P(1), which is obtained by multiplying an ordinary-ray refractive index no(1) of the selective reflection layer SR (in particular, the first reflection layer SR1) in the vicinity of the wavelength λp(1) by the helical pitch P(1) of the selective reflection layer SR (in particular, the first reflection layer SR1), and a value ne(1)P(1), which is obtained by multiplying an extraordinary-ray refractive index ne(1) by the helical pitch P(1), are set to meet the following relationship with respect to the peak wavelength λ(1): no(1)P(1) < λp(1) < ne(1)P(1).

Similarly, a value no(2)P(2), which is obtained by multiplying an ordinary-ray refractive index no(2) of the selective reflection layer SR (in particular, the second reflection layer SR2) in the vicinity of the wavelength λp(2) by the helical pitch P(2) of the selective reflection layer SR (in particular, the second reflection layer SR2), and a value ne(2)P(2), which is obtained by multiplying an extraordinary-ray refractive index ne(2) by the helical pitch P(2), are set to meet the following relationship with respect to the peak wavelength λp(2):

$$no(2)P(2) \; < \; \lambda p(2) \; < \; ne(2)P(2).$$

In like manner, a value no(3)P(3), which is obtained by multiplying an ordinary-ray refractive index no(3) of the selective reflection layer SR (in particular, the third reflection layer SR3) in the vicinity of the wavelength λp(3) by the helical pitch P(3) of the selective reflection layer SR (in particular, the third reflection layer SR3), and a value ne(3)P(3), which is obtained by multiplying an extraordinary-ray refractive index ne(3) by the helical pitch P(3), are set to meet the following relationship with respect to the peak wavelength λp(3): no(3)P(3) < λp(3) < ne(3)P(3).

At the same time, the reflection layers SR (1, 2, 3) including the individual selective reflection wavelength regions, which constitute the selective reflection layer SR, are set to have the helical pitches P(1), P(2) and P(3), which meet the relationships, ne(1)P(1) < no(2)P(2), and ne(2)P(2) < no(3)P(3) .

With this structure, too, a display device with excellent contrast characteristics and display luminance can be obtained.

In the above-described top-surface emission type display device, if the polarizer plate PP, 1/4 wavelength plate WP, selective reflection layer SR, organic active layer (light-emitting layer) 64, reflective film 60R and wiring substrate 120 provided with the organic active layer 64 are disposed in the named order, the organic active layer adjoins the reflective film 60R. Thus,almost all the circularly polarized light that is reflected by the selective reflection layer SR can be reflected by the reflective film 60R, and the above-described effect can sufficiently be obtained. Needless to say, this invention is applicable to a back-surface emission type display device that extracts EL light from the wiring substrate 120 (first electrode) side.

In the case of the back-surface emission type, the first electrode 60 is formed of an electrically conductive material that mainly has light transmissivity, and the second electrode 66 is formed of an electrically conductive material that mainly has light reflectivity. An organic active layer 64 functioning as a light-emitting layer is held between the first electrode 60 and second electrode 66, and thus an organic EL element 60 is constructed. In this example of the structure, the first electrode 60 does not include a reflective film, and the second electrode 66 functions as a reflective film.

Specifically, as show in FIG. 11, an organic EL element 40 including a reflective film 60R and an organic active layer 64 is disposed on a wiring substrate 120 and sealed. Then, a selective reflection layer SR, a 1/4 wavelength plate WP and a polarizer plate PP are successively disposed from the wiring substrate 120 side, and thus a back-surface emission type display device is fabricated. That is, the polarizer plate PP, 1/4 wavelength plate WP, selective reflection layer SR, wiring substrate 120 provided with organic active layer (light-emitting layer) 64, organic active layer 64 and reflective film (second electrode) 66 are disposed in the named order. For the purpose of simplicity, FIG. 11 depicts only the polarizer plate PP, 1/4 wavelength plate WP, selective reflection layer SR, organic active layer (light-emitting layer) 64, reflective film 60R and wiring substrate 120 provided with the organic active layer (light-emitting layer) 64. Depiction of other structural elements is omitted.

In the above-described structure, the distance between the selective reflection layer SR and the reflective film 66 increases by a degree corresponding to the thickness of the wiring substrate 120 and organic active layer 64. Hence, a parallax occurs. In this case, unless the distance between the selective reflection layer SR and the reflective film 66 is optimized relative to the pixel size, a displacement would occur between the circularly polarized light, which directly passes through the selective reflection layer SR from the organic active layer 64, and the light that is once reflected by the selective reflection layer SR, then reflected by the reflective film 66 with a phase difference of 180° , and then emerges from the selective reflection layer SR. In order to solve the problem of parallax, the thickness of the wiring substrate 120 needs to be set to be not greater than 10 times the pixel pitch. Thereby, the parallax becomes negligible in the range of practical viewing angles (e.g. ± 60° at which a distortion of image is negligible in a display with an ordinary aspect ratio of 4:3 or 16:9).

As a matter of course, even with the back-surface emission type display, the selective reflection layer SR may be formed with the same structure as in the above-described embodiment, and thus a display device with excellent contrast characteristics and display luminance can be obtained.

According to the present invention, if the above-described selective reflection layer SR is provided, effective advantages can be obtained with display devices which include light-emitting layers and employ circular polarizers each comprising a polarizer plate and a 1/4 wavelength plate. In other words, the same advantages can be obtained with display devices that include any type of light-emitting layers, such as inorganic EL elements, FED elements or PDP elements, aside from the above-described organic EL elements. In particular, in the case of the organic EL element or inorganic EL element, the reflective electrode (or reflective film) is provided under the light-emitting layer in order to enhance emission light luminance. Thus, the function of emitting light, which is reflected by the above-mentioned selective reflection layer, toward the viewer, is enhanced and more effective advantages can be obtained.

Industrial Applicability

As has been described above, the present invention can provide a display device that includes self-luminous elements and is capable of improving contrast characteristics and enhancing display luminance.

**Claims**

1. A display device including a reflecting layer, a light-emitting layer, a 1/4 wavelength plate and a polarizer plate, the 1/4 wavelength plate being positioned between the polarizer plate and the light-emitting layer, and the light-emitting layer being positioned between the 1/4 wavelength plate and the reflecting layer, the display device **characterized by** comprising:

   selective reflection layers that are disposed between the 1/4 wavelength plate and the light-emitting layer, include liquid crystal molecules that are aligned with a predetermined helical pitch, pass first circularly polarized light, and reflect second circularly polarized light that has a polarity opposite to a polarity of the first circular polarized light and has a predetermined wavelength,
   wherein the light-emitting layer has at least one peak wavelength, and the selective reflection layers include an m-number of selective reflection regions when the number of peak wavelengths is m,
   when a peak wavelength of light emerging from the light-emitting layer is $\lambda p(k)$ ($k = 1, 2, ..., m$ in an order from a smallest wavelength), the peak wavelength $\lambda p(k)$ is less than a value $ne(k)P(k)$ that is obtained by multiplying an extraordinary-ray refractive index $ne(k)$ of the selective reflection layer that forms each selective reflection region by a helical pitch $P(k)$, and is greater than a value $no(k)P(k)$ that is obtained by multiplying an ordinary-ray refractive index $no(k)$ by the helical pitch $P(k)$, and
   a relationship, $ne(k - 1) P(k - 1) < no(k)P(k)$, is established between the selective reflection layers that form the selective reflection regions.

2. A display device including a reflecting layer, a light-emitting layer, a color filter, a 1/4 wavelength plate and a polarizer plate, the 1/4 wavelength plate being positioned between the polarizer plate and the color filter, and the color filter being positioned between the 1/4 wavelength plate and the light-emitting layer, the display device **characterized by** comprising:

   selective reflection layers that are disposed between the 1/4 wavelength plate and the color filter, include liquid crystal molecules that are aligned with a predetermined helical pitch, pass first circularly polarized light, and reflect second circularly polarized light that has a polarity opposite to a polarity of the first circular polarized light and has a predetermined wavelength,
   wherein light that is emitted from the light-emitting layer and transmitted through the color filter has at least one peak wavelength, and the selective reflection layers include an m-number of selective reflection regions when the number of peak wavelengths is m,
   when a peak wavelength of light emerging from the color filter is $\lambda p(k)$ ($k = 1, 2, ..., m$ in an order from a smallest wavelength), the peak wavelength $\lambda p(k)$ is less than a value $ne(k)P(k)$ that is obtained by multiplying an extraordinary-ray refractive index $ne(k)$ of the selective reflection layer that forms each selective reflection region by a helical pitch $P(k)$, and is greater than a value $no(k)P(k)$ that is obtained by multiplying an ordinary-ray refractive index $no(k)$ by the helical pitch $P(k)$, and
   a relationship, $ne(k - 1)P(k - 1) < no(k)P(k)$, is established between the selective reflection layers that form the selective reflection regions.

3. The display device according to claim 1, **characterized in that** a value n(k)P(k), which is obtained by multiplying a mean refractive index n(k) of the selective reflection layers by the helical pitch P(k), is substantially equal to the peak wavelength λp(k) of the light-emitting layer.

4. The display device according to claim 2, **characterized in that** a value n(k)P(k), which is obtained by multiplying a mean refractive index n(k) of the selective reflection layers by the helical pitch P(k), is substantially equal to the peak wavelength λp (k) of the light-emitting layer.

5. The display device according to claim 1, **characterized in that** a reflectance of the second circular polarized light, which is reflected by the selective reflectance layer, is 50% or more at the peak wavelength λp(k) of the light-emitting layer.

6. The display device according to claim 2, **characterized in that** a reflectance of the second circular polarized light, which is reflected by the selective reflectance layer, is 50% or more at the peak wavelength λp(k) of the light-emitting layer.

7. The display device according to claim 1, **characterized in that** at least a red pixel with a red peak wavelength, a green pixel with a green peak wavelength and a blue pixel with a blue peak wavelength are arrayed in a planar fashion, and means for individually driving the respective pixels is provided.

8. The display device according to claim 2, **characterized in that** at least a red pixel with a red peak wavelength, a green pixel with a green peak wavelength and a blue pixel with a blue peak wavelength are arrayed in a planar fashion, and means for individually driving the respective pixels is provided.

9. The display device according to claim 1,
**characterized in that** the reflecting layer, the light-emitting layer, the selective reflection layer, the 1/4 wavelength plate and the polarizer plate are disposed on a substrate in the named order.

10. The display device according to claim 2, **characterized in that** the reflecting layer, the light-emitting layer, the selective reflection layer, the 1/4 wavelength plate and the polarizer plate are disposed on a substrate in the named order.

11. The display device according to claim 7, **characterized in that** the selective reflection layer, the 1/4 wavelength layer and the polarizer plate are disposed on one major surface of a substrate in the named order, and the light-emitting layer and the reflecting layer are disposed on the other major surface of the substrate in the named order, and a thickness of the substrate is not greater than 10 times a pitch of arrangement of the pixels.

12. The display device according to claim 8, **characterized in that** the selective reflection layer, the 1/4 wavelength layer and the polarizer plate are disposed on one major surface of a substrate in the named order, and the light-emitting layer and the reflecting layer are disposed on the other major surface of the substrate in the named order, and a thickness of the substrate is not greater than 10 times a pitch of arrangement of the pixels.

13. The display device according to claim 1, **characterized in that** the light-emitting layer is held between a pair of electrodes, thus constituting an EL element.

14. The display device according to claim 2, **characterized in that** the light-emitting layer is held between a pair of electrodes, thus constituting an EL element.

15. The display device according to claim 1, **characterized in that** the selective reflection layer is one of a cholesteric liquid crystal'layer, a layer obtained by polymerizing a cholesteric liquid crystal layer, and a layer obtained by forming a cholesteric liquid crystal layer in a film shape.

16. The display device according to claim 2, **characterized in that** the selective reflection layer is one of a cholesteric liquid crystal layer, a layer obtained by polymerizing a cholesteric liquid crystal layer, and a layer obtained by forming a cholesteric liquid crystal layer in a film shape.

17. A display device **characterized by** comprising a reflecting layer, alight-emitting layer, a selective reflection layer, a 1/4 wavelength plate and a polarizer plate, which are disposed in the named order,

wherein the light-emitting layer includes a first light-emitting layer that emits light with a single first peak wavelength, and a second light-emitting layer that emits light with a single second peak wavelength, and
the selective reflection layer passes first circularly polarized light, reflects second circularly polarized light that has a polarity opposite to a polarity of the first circular polarized light and has a predetermined wavelength, and includes a first reflection layer that includes liquid crystal molecules aligned with a first helical pitch corresponding to the first peak wavelength and reflects the second circularly polarized light of a predetermined wavelength including the first peak wavelength, and a second reflection layer that includes liquid crystal molecules aligned with a second helical pitch corresponding to the wavelength of the second light-emitting layer and reflects the second circularly polarized light of a predetermined wavelength including the second peak wavelength.

18. A display device including a reflecting layer, a light-emitting layer, a 1/4 wavelength plate and a polarizer plate, the 1/4 wavelength plate being positioned between the polarizer plate and the light-emitting layer, and the light-emitting layer being positioned between the 1/4 wavelength plate and the reflecting layer, the display device **characterized by** comprising:

a selective reflection layer that is disposed between the 1/4 wavelength plate and the light-emitting layer, passes first circularly polarized light, and reflects second circularly polarized light that has a polarity opposite to a polarity of the first circular polarized light and has a predetermined wavelength,
light that is emitted from the light-emitting layer has at least one peak wavelength $\lambda p$, and
the selective reflection layer reflects light corresponding to a specified wavelength range including the peak wavelength $\lambda p$.

FIG.1

EP 1 677 274 A1

FIG. 2

FIG. 3

FIG.4

FIG. 5

External light of wavelength other than peak wavelength of light-emitting layer

⟷ : Linearly polarized light parallel to transmission axis of polarizer plate

⟋ : Linearly polarized light parallel to absorption axis of polarizer plate

◯ : Counterclockwise circularly polarized light

◯ : Clockwise circularly polarized light

Emission light

PP

WP

SR

64

120

40   60R

**FIG. 6**

PP
WP
SR

64

120

40   60R

**FIG. 7**

Emission light transmittance (Relative value)

FIG. 8

Anti-reflection function

FIG. 9

CFR            CFG          CFB         PP

WP

SR

CF

64

120

40                              60R

## FIG. 10

PP

WP

SR

120

64

66

40

## FIG. 11

# INTERNATIONAL SEARCH REPORT

| International application No. |
|---|
| PCT/JP2004/015731 |

**A. CLASSIFICATION OF SUBJECT MATTER**
Int.Cl⁷ G09F9/00, G09F9/30, H05B33/12

According to International Patent Classification (IPC) or to both national classification and IPC

**B. FIELDS SEARCHED**

Minimum documentation searched (classification system followed by classification symbols)
Int.Cl⁷ G09F9/00, G02F1/1335-1/13363

Documentation searched other than minimum documentation to the extent that such documents are included in the fields searched
Jitsuyo Shinan Koho          1922-1996     Jitsuyo Shinan Toroku Koho     1996-2004
Kokai Jitsuyo Shinan Koho     1971-2004     Toroku Jitsuyo Shinan Koho     1994-2004

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2003-186413 A (Hitachi, Ltd.), 04 July, 2003 (04.07.03), Full text; all drawings & US 2003/127656 A1 | 1-18 |
| Y | JP 2001-357979 A (Toshiba Corp.), 26 December, 2001 (26.12.01), Par. Nos. [0015] to [0031]; Fig. 1 (Family: none) | 11,12 |
| A | JP 11-66933 A (Nitto Denko Corp.), 09 March, 1999 (09.03.99), Abstract; Par. Nos. [0019] to [0028] (Family: none) | 1-18 |

☒ Further documents are listed in the continuation of Box C.      ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>05 January, 2005 (05.01.05) | Date of mailing of the international search report<br>25 January, 2005 (25.01.05) |
|---|---|
| Name and mailing address of the ISA/<br>Japanese Patent Office | Authorized officer |
| Facsimile No. | Telephone No. |

Form PCT/ISA/210 (second sheet) (January 2004)

| INTERNATIONAL SEARCH REPORT | International application No. |
|---|---|
| | PCT/JP2004/015731 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 11-84378 A (Toshiba Corp.),<br>26 March, 1999 (26.03.99),<br>Abstract; Par. Nos. [0019] to [0020]; Figs. 6, 7<br>& US 6333724 B1 | 1-18 |
| A | JP 2003-227933 A (Nitto Denko Corp.),<br>15 August, 2003 (15.08.03),<br>Full text; all drawings<br>(Family: none) | 1-18 |
| P,A | JP 2004-30955 A (Hitachi, Ltd.),<br>29 January, 2004 (29.01.04),<br>Abstract<br>& US 2004/051445 A1 | 1-18 |
| E,A | JP 2004-361774 A (Sumitomo Chemical Co., Ltd.),<br>24 December, 2004 (24.12.04),<br>Abstract<br>(Family: none) | 1-18 |

Form PCT/ISA/210 (continuation of second sheet) (January 2004)

## INTERNATIONAL SEARCH REPORT

International application No.

PCT/JP2004/015731

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
    The technical feature common to the inventions of claims 1-18 is a display in which a reflecting layer, a light-emitting layer, a selective reflecting layer, a quarter-wavelength plate, a polarizing plate are arranged sequentially in this order and in which the selective reflecting layer transmits a first circularly polarized light and reflects a second circularly polarized light having a polarity opposite to that of the first circularly polarized light.
    However, the international search has revealed that this technical feature is included in the conventionally known prior art.
    (continued to extra sheet)

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**    ☐ The additional search fees were accompanied by the applicant's protest.

☐ No protest accompanied the payment of additional search fees.

Form PCT/ISA/210 (continuation of first sheet (2)) (January 2004)

24

**EP 1 677 274 A1**

**INTERNATIONAL SEARCH REPORT**

International application No.

PCT/JP2004/015731

<u>Continuation of Box No.III of continuation of first sheet(2)</u>

Consequently, the technical feature is not a special technical feature within the meaning of PCT Rule 13.2, second sentence.
Therefore, there is no technical feature common to all the claims.

Form PCT/ISA/210 (extra sheet) (January 2004)

25